# EUROPEAN PATENT SPECIFICATION

(11) **EP 3 304 622 B1**
(45) Date of publication and mention of the grant of the patent: **05.08.2020**
(21) Application number: 16732952.3
(22) Date of filing: 01.06.2016
(51) Int. Cl.: H01M 4/134, H01M 4/38, C30B 29/60, C30B 29/52

(54) **A NANOWIRE HETEROSTRUCTURE**
HETEROSTRUKTURNANODRAHT
HÉTÉROSTRUCTURE DE NANOFILS

(30) Priority: 03.06.2015 EP 15170563
(43) Date of publication of application: 11.04.2018
(73) Proprietor: University of Limerick, Limerick (IE)
(72) Inventor: RYAN, Kevin, M., Limerick (IE); KENNEDY, Tadhg, Limerick (IE)
(74) Representative: Purdylucey Intellectual Property
(86) International application number: PCT/EP2016/062415
(87) International publication number: WO 2016/193324

(56) References cited:
- EP-A2- 2 175 053
- WO-A2-2008/033303
- WO-A2-2012/027360
- TADHG KENNEDY ET AL: "Nanowire Heterostructures Comprising Germanium Stems and Silicon Branches as High-Capacity Li-Ion Anodes with Tunable Rate Capability", ACS NANO, vol. 9, no. 7, 30 June 2015 (2015-06-30), pages 7456-7465, XP055206932, ISSN: 1936-0851, DOI: 10.1021/acsnano.5b02528
- TAESEUP SONG ET AL: "Electrochemical Properties of Si-Ge Heterostructures as an Anode Material for Lithium Ion Batteries", ADVANCED FUNCTIONAL MATERIALS, WILEY - V C H VERLAG GMBH & CO. KGAA, DE, vol. 24, no. 10, 17 October 2013 (2013-10-17), pages 1458-1464, XP001588415, ISSN: 1616-301X, DOI: 10.1002/ADFM.201302122 [retrieved on 2013-10-17]
- AARON M. CHOCKLA ET AL: "Colloidal Synthesis of Germanium Nanorods", CHEMISTRY OF MATERIALS, vol. 23, no. 7, 3 March 2011 (2011-03-03), pages 1964-1970, XP055293967, US ISSN: 0897-4756, DOI: 10.1021/cm2001607
- DELI WANG ET AL: "Rational growth of branched and hyperbranched nanowire structures", NANO LETTERS, AMERICAN CHEMICAL SOCIETY, US, vol. 4, no. 5, 1 May 2004 (2004-05-01), pages 871-874, XP009094914, ISSN: 1530-6984, DOI: 10.1021/NL049728U
- KOLASINSKI ET AL: "Catalytic growth of nanowires: Vapor-liquid-solid, vapor-solid-solid, solution-liquid-solid and solid-liquid-solid growth", CURRENT OPINION IN SOLID STATE AND MATERIALS SCIENCE, ELSEVIER SCIENCE LTD, OXFORD, GB, vol. 10, no. 3-4, 9 June 2007 (2007-06-09) , pages 182-191, XP022110414, ISSN: 1359-0286

## Description

### Field of the Invention

The present invention is concerned with providing a nanowire structure for as-an electrode in a lithium ion battery. More particularly, the invention is concerned with providing a nanowire structure for an electrode which can be tailored to suit the application in which the battery is intended to be used.

### Background to the Invention

Li-ion batteries are used in a wide spectrum of applications that have very different power requirements. For instance, some applications need power to be delivered quickly, such as for example power tools that often require very high discharge rates. Other applications, such as mobile phones, are discharged at relatively slower rates. In such cases having a high capacity is the priority as it prolongs the time between charges.

Due to the ever increasing demand for portable electronic devices and the rapidly expanding electric vehicle market, it has become very desirable to produce a high-capacity electrode material that can increase the energy density of lithium-ion batteries. Li-alloying materials such as Silicon (Si) and Germanium (Ge) have emerged as the forerunners to replace the current, relatively low-capacity, carbonaceous based anodes. Germanium and silicon undergo a volume expansion and contraction during the charge and discharge processes, which creates large mechanical stresses within the electrode. When bulk films and micrometre-sized particles are used as electrodes in lithium-ion batteries, capacity fading occurs, due to pulverization and the loss of electrical contact between the active material and the current collector. This results in a short battery life time for bulk electrodes.

The benefit of using pure Si electrodes is that it has the highest known specific capacity of any material and also is inexpensive. However, all pure Si electrodes suffer from the major disadvantage of a relatively poor rate capability due to the inherently low conductivity of Si and slow rates of Li⁺ diffusivity. In an attempt to overcome this problem, nanowire (NW) based arrangements have been utilised with some success. When grown directly from the current collector, the NW morphology outperforms bulk materials, as each individual NW remains electrically contacted, despite the large volume fluctuations occurring as a result of constant alloying and dealloying. The ease of processability and uncomplicated, binder-free nature of such electrodes make them highly attractive as next-generation Li-ion anode materials. In an attempt to extend the cycle life, more complex binder-free NW arrangements have also been fabricated. These include carbon-silicon and crystalline-amorphous core-shell structures, NWs coated with conductive inactive materials and NWs grown via AAO template assisted growth. Although all of these systems show some improvements in capacity retention, they suffer from the same major disadvantage of all Si electrodes, namely that of a relatively poor rate capability due to the inherently low conductivity of Si and slow rates of Li⁺ diffusivity.

A further problem encountered with Si NW electrodes is the continuous growth of the passivating SEI layer. The formation of a stable, thin SEI layer in the initial cycles is essential, as it prevents continuous decomposition of the electrolyte during each charge process. However, if the SEI is not flexible and cohesive, then the continuous expansion and contraction of the NWs during cycling can lead to cracking of the passivating layer. This re-exposes the active material causing further decomposition of the electrolyte on the surface, and thickening of the SEI layer with each cycle. This ultimately inhibits the performance of the NWs over extended cycles as it increases the cell's internal impedance on the surface of the active material due to the decomposition of the electrolyte.

Ge NW electrodes show a much superior rate capability over Si, due to the high conductivity and high rate of diffusivity of Li, thus making them suitable for high-rate applications. Furthermore Ge NW electrodes exhibit high capacities and very long cycle lives in long term cycling experiments at rates of 1C. The low capacity fade of these electrodes is due to the transformation of the NWs over the initial cycles into a sponge like network of Ge ligaments which remains well contacted to the current collector despite the volume changes occurring. However, the drawback of Ge NW electrodes is that they have a lower capacity and are more expensive to fabricate than Si electrodes.

Traditional methods for preparing electrodes are multi-step processes. The active material is first mixed with conducting carbon and a nonconducting polymeric binder (such as polyvinylidene fluoride) in an inorganic solvent (NMP). The resulting slurry is coated onto a current collector, pressed and then annealed for several hours. Such preparation methods are not ideal, as the whole process is time consuming and the solvent used in the slurry formulation is expensive, toxic and generates flammable vapors. Another major disadvantage is that the binder and conductive additives are electrochemically inactive, yet still add mass to the electrode. This results in a limit of the achievable capacity.

The paper entitled "Growth of Ge-Si nanowire heterostructures via chemical vapour deposition", published in the Thin Solid Films publication, vol. 519 no. 13, 12 February 2011, discloses the growing of Ge NW stems from a Si wafer via a gold seeded chemical vapour deposition mechanism, with the migrated gold acting as a seed for Si NW branch growth. However, there are a number of disadvantages of the resulting heterostructure were it to be used as an electrode in a lithium ion battery. The heterostructure formed by this technique results in Si branches only growing from the top of the Ge NW stems. This means that there would be very little interconnection between neighbouring NWs and branches, which is necessary for the stable cycling of Li-alloying materials such as Ge and Si in a Li-ion battery, where the NWs must undergo a complete restructuring to form a continuous porous network that is mechanically robust. Secondly, the described technique does not provide any control over the diameter of the Si NW branches, which is necessary to inhibit the effects of the large volume change (up to 370%) that can occur in Si during the charging / discharging process in a Li-ion battery, which leads to poor cycling performance due to the pulverisation of the active material and loss of electrical contact. The technique also does not allow any control of the density of the Si NW branches. Furthermore, this technique utilises gold as a catalyst. However gold is expensive, its contribution to the capacity of an electrode is negligible, and an excess of gold on the NWs has been shown to cause large irreversible capacity loss, poor performance and considerable capacity fade in a Li-ion electrode. The paper entitled "Epitaxial core-shell and core-multishell nanowire heterostructures", published in the Nature publication vol. 420, no. 6911, 7 November 2002 discloses the synthesis of Si or Ge NWs using a gold catalyst deposited on the surface of an oxidised Si wafer. The NWs are grown using either silane or germane as Si or Ge precursors respectively. The Si shell is then deposited in a high pressure system using the same precursor. The heterostructure formed by this technique results in a NW having a long straight morphology, which results in little interconnection between neighbouring NWs and branches, which, as explained above, is desirable in order to provide a Li-ion battery of good performance. Furthermore, this synthesis technique is complex, and thus of high cost and low throughput. The use of high pressures and highly flammable precursors at high temperatures also makes the system described in this paper inherently very dangerous. International Patent Publication No. WO 2008/033303 describes branched nanoscale wires.

It is an object of the present invention to provide a material suitable for an electrode in a lithium ion battery which overcomes at least some of the above mentioned problems.

### Summary of the Invention

The invention is defined in the appended claims.

The present invention provides a Silicon-Germanium, Si-Ge, heterostructure for an electrode in a lithium ion battery.

The present invention also provides a method for synthesising a silicon-germanium, Si-Ge, heterostructure for an electrode in a lithium ion battery, the method comprising the steps of:
synthesising a Ge nanowire;
attaching a plurality of tin nanoparticles to the Ge nanowire; and
growing silicon nanowire branches from the Ge nanowire by means of the tin nanoparticles acting as a seed material.

### Brief Description of the Drawings

The invention will be more clearly understood from the following description of an embodiment thereof, given by way of example only, with reference to the accompanying drawings, in which:-
Figure 1 shows a process flow of the main steps involved in a first embodiment of synthesising the heterostructure of the present invention wherein the heterostructure comprises a Si-Ge heterostructure;
Figures 2a and 2b show low and high resolution HRSEM images of the synthesised Ge nanowires;
Figures 2c and 2d show low and high resolution HRSEM images of the Ge nanowires with Sn nanoparticles attached to the surface in accordance with the first embodiment of the invention;
Figures 2e and 2f show low and high resolution HRSEM images of the Si nanowire branches growing in high density from the GE nanowires in accordance with the first embodiment of the invention;
Figure 3a shows a STEM image of the Ge nanowire with Si Branches in accordance with the first embodiment of the invention;
Figure 3b shows an EDX elemental map of the Ge and the Si in the synthesised heterostructure of the first embodiment of the invention;
Figure 3c shows a low resolution TEM image of a straight Ge nanowire with Si branches growing in high density from it in accordance the first embodiment of the invention;
Figure 3d and Figure 3e show high resolution TEM images of the two highlighted areas of the Ge nanowire and the Si branch of Figure 3c;
Figure 3f shows the XRD pattern obtained from a Ge nanowire with Si branches in accordance with the first embodiment of the invention;
Figure 4 shows a process flow of the main steps involved in a second embodiment of synthesising the Si-Ge heterostructure of the present invention;
Figure 5a shows the discharge capacities and Coulombic efficiencies for Ge to Si mass ratios of 2:1, 3:1 and 4:1 of the first embodiment of the invention, each composition cycled at a C/5 rate;
Figure 5b shows the percentage capacity retention of the Si-Ge branched nanowire heterostructure of the first embodiment of the invention for Ge to Si mass ratios of 2:1, 3:1 and 4:1 plotted alongside the capacity retention for a pure Si nanowire electrode;
Figure 5c shows the rate capability of the branched nanowire heterostructure of the first embodiment of the invention for Ge to Si mass ratios of 2:1, 3:1 and 4:1 and for a pure Si nanowire electrode through charging and discharging the material for 5 cycles at rates of C/10, C/5, C/2, C, 2C, 5C, 10C and then back to C/10;
Figure 5d shows the percentage capacity retention of the branched nanowire heterostructure of the first embodiment of the invention for Ge to Si mass ratios of 2:1, 3:1 and 4:1 and for a pure Si nanowire electrode through charging and discharging the material for 5 cycles at rates of C/10, C/5, C/2, C, 2C, 5C, 10C and then back to C/10;
Figure 6a and Figure 6b show low and high magnification HRSEM images of the branched nanowire heterostructure of the first embodiment of the invention (2:1 composition) after 100 cycles;
Figure 6c and Figure 6d show low and high magnification HRTEM images of the branched nanowire heterostructure of the first embodiment of the invention (2:1 composition) after 100 cycles; and
Figure 7a shows a low magnification STEM image of the branched nanowire heterostructure of the first embodiment of the invention after 100 cycles and Figure 7ai and 7aii shows EDX elemental maps of Si and Ge respectively;
Figure 7b shows a high magnification STEM image of the branched nanowire heterostructure of the first embodiment of the invention after 100 cycles and
Figure 7bi and 7bii shows EDX elemental maps of Si and Ge respectively; and
Figure 7c shows the raman spectra of the branched nanowire heterostructure of the first embodiment of the invention after 50 cycles compared to a pure Si nanowire and a pure Ge nanowire.

### Detailed Description of the Drawings

The present invention discloses a heterostructure which is suitable for an electrode in a lithium ion battery. The heterostructure comprises a nanowire stem of a first Li-alloying material. A second Li-alloying material is distributed along the entire length of the surface of the nanowire stem.

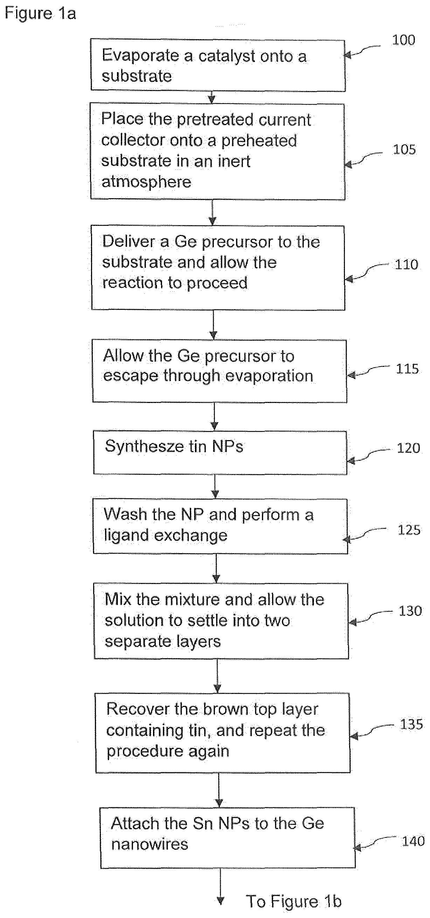

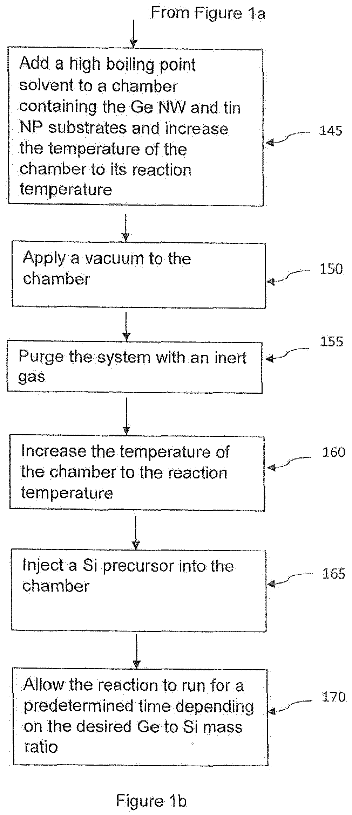

In accordance with the first embodiment for synthesising the heterostructure of the present invention, the heterostructure is synthesised as a branched NW heterostructure comprising a Ge stem contacted directly to the current collector, with Si branches growing from the surface of the Ge. Figure 1 shows a process flow of the main steps involved in the synthesis of this embodiment.

In step 100, a current collector is obtained by evaporating a catalyst onto a substrate, which in this embodiment is stainless steel. However, it should be appreciated that the current collector could equally well be other metals, such as for example copper, nickel, aluminium or platinum. In this embodiment, this involves evaporating copper 99.99% Cu in a glovebox based evaporation unit, with the Cu having a thickness of between 1 and 20 nm. However, many alternative catalysts could equally well be used, such as for example Sn, Au, In, Bi, and Ni. In step 105, the pretreated current collector is placed vertically onto a preheated substrate in an inert atmosphere. The substrate is preheated to approximately 430°C. A stainless steel confiner is then placed over the substrate, to prevent the escape of a Ge precursor. In step 110, a Ge precursor is delivered to the substrate and the reaction is allowed to proceed for at least 1 minute. In this embodiment, the Ge precursor comprises diphenylgermane, and the delivery is provided by means of an injection using a microliter syringe through a small hole in the top of the confiner. However, any other suitable Ge precursor could be used, such as for example triphenylgermane, triphenylgermane/phenyl silane mixture, phenylgermane, trichlorogermane, tetraethylgermane, tetramethylgermane or trigermane.

The reaction allows the Ge NWs to grow from the current collector via either a vapour-solid-solid mechanism or a vapour-liquid-solid mechanism, depending on the catalyst used. In step 115, the reaction is terminated by removing the confiner and allowing the Ge precursor to escape through evaporation.

In step 120, tin nanoparticles, (Sn NP) are synthesized through any known procedure. It should be noted that the plurality of Si branches which will be grown from the surface of the Ge NWs will be proportional to the size of the tin nanoparticles. In addition, the concentration of the Sn nanoparticle solution determines the density of the plurality of the Si branches which will be grown. Thus, the size and the concentration of the tin nanoparticles to be synthesized is selected in accordance with the desired size and density of the plurality of the Si branches to be grown from the surface of the Ge NWs.

Once the Sn NPs are synthesised, the NPs are washed and a ligand exchange performed (step 125). This is achieved in accordance with the present embodiment by adding 1 mL of hexane, 1 mL of Octadecene and 5 drops of Oleic acid to 1 mL of the Sn NP dark brown reaction mixture. The resulting mixture is then mixed thoroughly, such as for example through the use of a vortex mixer, and the solution allowed to settle into two separate layers (step 130). In step 135, the bottom colourless layer is discarded, while the brown top layer containing the Sn nanoparticles is recovered. This procedure is then repeated once more, and the brown solution containing the Sn NPs recovered and used without further purification.

In step 140, the Sn NPs are covalently attached to the Ge NWs. This may be achieved by immersing the Ge NW substrates in ethanedithiol (EDT) for approximately 1 hour. The substrates are then removed and rinsed, dried, and immersed in the Sn NPs solution. In accordance with this embodiment, the immersion in the Sn NP solution is for approximately 24 hours. The substrates are then washed thoroughly with hexane and dried with a nitrogen line.

In order to grow the Si branches from the surface of the GE NWs, the SN NPs are used as secondary seeds for Si NW growth. This involves a reaction being carried out between a Si precursor and the Sn NPs on Ge NWs. This reaction is carried out by placing the Ge NW with Sn NPs substrates vertically in a chamber. This chamber may be a round bottomed Pyrex flask which is attached to a schlenk line setup to provide a vacuum to the chamber via a water condenser. In step 145, a high boiling point solvent is added to the chamber and the temperature of the system is then increased to its reaction temperature. By holding the solvent under vacuum and increasing the temperature of the chamber, the solvent is de-gassed and any impurities are removed from it. In accordance with this embodiment, 7mls of the solvent squalane is added and the temperature is increased to 125 °C through the use of a three zone furnace. A vacuum of at least 100 mTorr is then applied to remove moisture from the system (step 150). This vacuum is applied for approximately 1 hour. Following this, the system is purged with argon (Ar) (step 155). By purging the system with argon, an inert environment is provided in which the reaction can take place. In step 160, the temperature of the chamber is increased to the reaction temperature of approximately 460 °C under a constant flow of argon gas, to achieve a reflux (step 160). A water condenser is used to control the solvent reflux and ensure that the reaction is kept under control. In step 165, once the system has reached the correct reaction temperature, the Si precursor is injected into the chamber. In the described embodiment, the Si precursor comprises phenylsilane and it is injected through a septum cap into the chamber. The reaction is then allowed run for a predetermined time period, depending on the desired Ge to Si mass ratio (step 170). It will be appreciated in this regard that the longer the reaction time, the greater the concentration of Si in the resulting heterostructure. To terminate the reaction, the furnace is opened and the setup allowed to cool to room temperature before extracting the substrates.

The resulting heterostructure comprises a GE NW with Si branches distributed along the entire length of the surface of the Ge NW. As previously mentioned, the size of the Sn nanoparticles used for secondary seeding can be controlled in the process of the present invention, which in turn dictates the diameter of the Si branches. This is very desirable when the resulting heterostructure is being used in a Li-ion battery, in order to inhibit the deleterious effects of the volume change which occurs during the charging / discharging process in a Li-ion battery, which leads to poor cycling performance due to the pulverisation of the active material and loss of electrical contact. Thus, the present invention enables the NW diameter to be kept at a minimum, and thus reduces the negative effects of volume expansion.

In this embodiment of the invention where the single electrode is fabricated from a combination of Si and Ge materials, the electrode can benefit both from the excellent rate characteristics of Ge, as well as the high capacity and lower cost of Si. In addition, such a structure enables the cycling properties of the electrode to be tailored to the end application. Thus for example, if an electrode is being fabricated for an application requiring higher capacity than rate capability, it can be fabricated with higher Si content than Ge content. Conversely, if an electrode is being fabricated for an application requiring a higher rate capability than capacity, it can be fabricated with a higher Ge content than Si content.

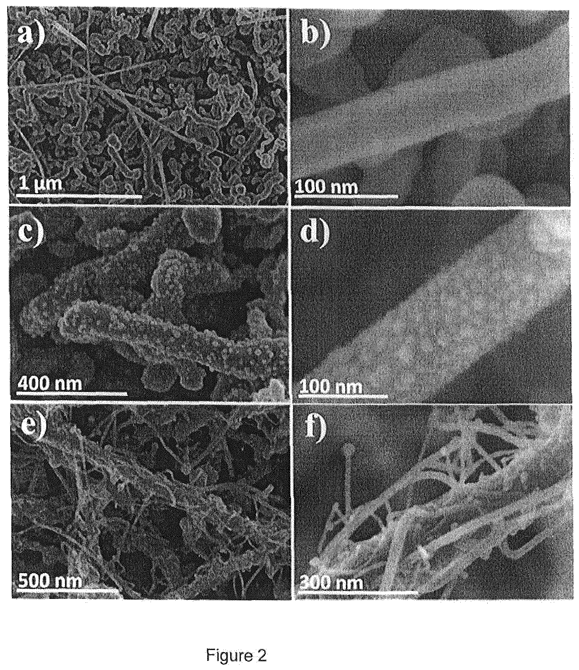

Figures 2a and 2b show low and high resolution images of the synthesised Ge NWs of this first embodiment of the invention. The NWs exhibit two distinct morphological forms. It can be seen from the figure that the majority of the NWs have a tortuous, wormlike appearance with an average diameter of 74 nm. The remainder of the NWs are straight with a narrower average diameter of 39 nm. Figures 2c and 2d show low and high resolution images of the Ge NWs with the Sn NPs attached to the surface, while Figures 2e and 2f show low and high resolution images of the Ge nanowires with the Si NW branches.

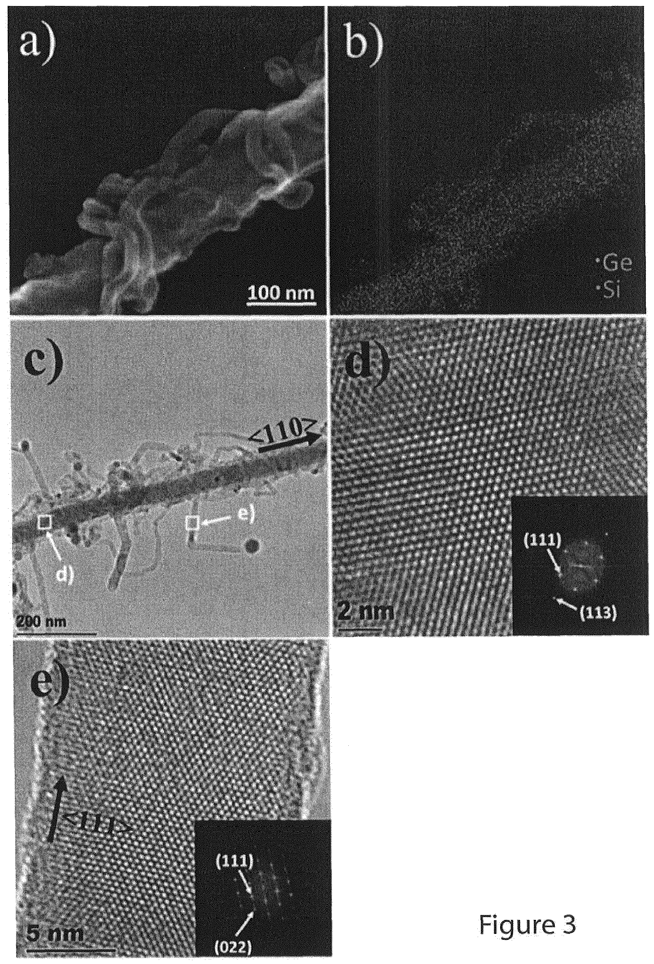

Figure 3a shows a STEM image of the Ge NW with Si Branches of this first embodiment of the invention. It can be seen that the branches grow in a vine like manner around the Ge NW creating multiple contact points between the two. Figure 3b shows an EDX elemental map of the Ge and the Si in the synthesised heterostructure showing signals from Ge and from Si overlaid. It should be noted that the material is similar to a core-shell like structure, with the distinction that the Si branches do not constrain the Ge NW during cycling. Figure 3c shows a low resolution TEM image of a straight Ge NW with Si branches growing in high density from it.

High resolution TEM images of the highlighted areas of the Ge NW and the Si branch of Figure 3c are presented in Figure 3d and Figure 3e respectively. The straight Ge NW is single crystal and has a (110) growth direction, typically seen for Cu₃Ge-seeded NWs (Figure 3d). The inset fast Fourier transform (FFT) pattern is indexed with spots corresponding to the (111) and (113) planes, matching those expected for cubic Ge. The HRTEM image of the Si branch (Figure 3e) shows an FFT pattern indexed with spots corresponding to the (111) and (022) planes and is consistent with a <111> growth direction.

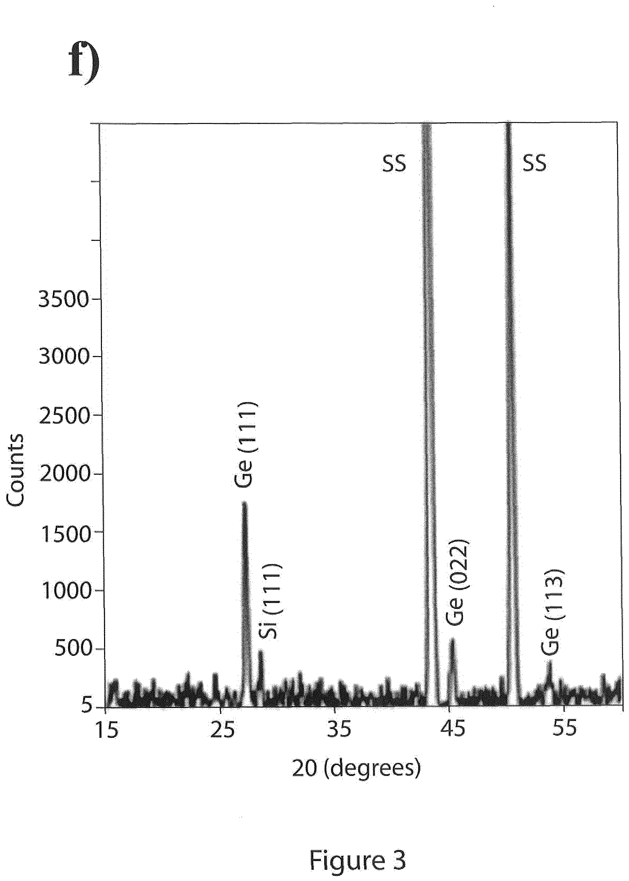

Figure 3f shows the XRD pattern obtained from the Ge NW with Si branches substrate showing reflections corresponding to cubic Ge, cubic Si and the SS current collector. No peaks were identified for the c-Cu₃Ge and c-Sn seeds, which was due to the comparatively low mass of each in the material.

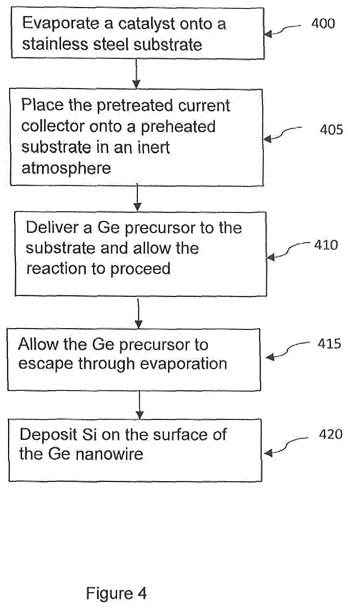

In a reference embodiment for synthesising the heterostructure not according to the present invention, Ge NWs are grown directly from the current collector with a Si shell deposited on their surface. Figure 4 shows a process flow of the main steps involved in the synthesis of this embodiment.

Steps 400 to 415 of this embodiment involve the synthesis of Ge NWs, and are identical to steps 100 to 115 described in relation to the first embodiment. Once the Ge NWs are synthesised, Si is deposited on the surface of the Ge NWs such that it is distributed along the entire length of the surface of the Ge NW (step 420). In this embodiment, this is achieved through the use of a plasma-enhanced chemical vapor deposition machine. As was the case in respect of the first embodiment, the desired Ge to Si mass ratio is obtained by varying the deposition time, with a longer deposition time resulting in a higher Si content.

This process of the second embodiment results in the creation of a tortuous core-shell heterostructure. During use as an electrode, this tortuosity promotes the formation of a stable porous network of active material, and thus leads to a Li-ion battery having good performance characteristics. While the described embodiments of the invention illustrate the process of the present invention for synthesising a Si-Ge NW heterostructure, it should be appreciated that the process of the present invention could equally well be applied in order to synthesise NW heterostructures comprising any other suitable Li-alloying materials. For example, the process of the present invention could be applied to synthesise a NW heterostructure comprising a Si stem having either Ge branches or a Ge shell, or a NW heterostructure comprising a Si stem having either Si branches or a Si shell, or indeed a NW heterostructure comprising a Ge stem having either Ge branches or a Ge shell. These combinations are not part of the invention.

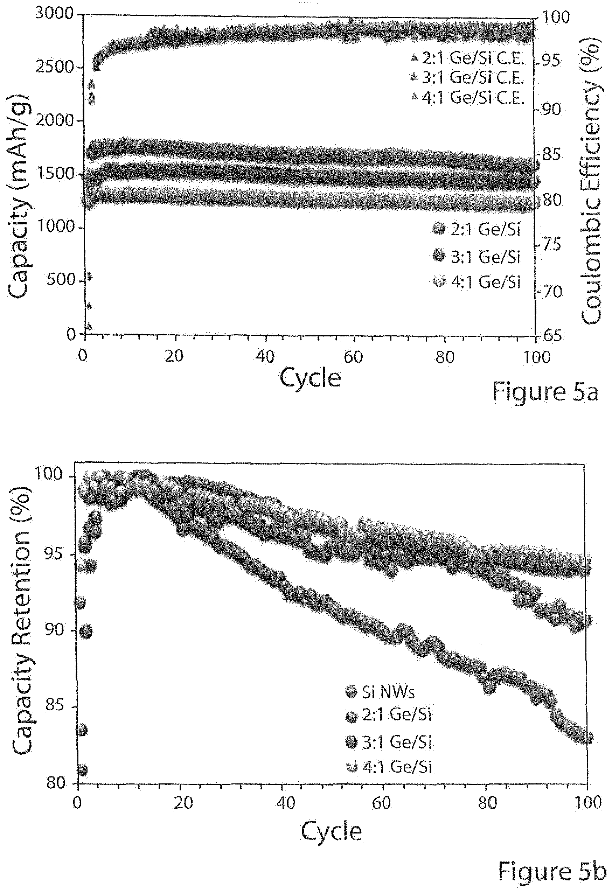

The electrochemical properties of the branched NWs synthesised in accordance with the first embodiment of the invention may be illustrated by galvanostatic cycling in a two electrode Swagelok cell cycled in the voltage range of 0.01 to 1.0 V versus Li/Li⁺ in a 1 M LiPF₆ in EC/DMC (1:1 v/v) + 3 wt% VC electrolyte, and evaluating the electrochemical properties of three different Ge to Si mass ratios, such as 2:1, 3:1 and 4:1 Ge to Si, with each having maximum theoretical specific capacities of 2115, 1933 and 1823 mAh/g respectively. The electrochemical processes occurring during charging and discharging the material at a C/5 rate for 100 cycles can be shown by plotting the differential capacity of the 1^{st} and 2^{nd} cycles of each composition, which shows the dual cycling of both the Ge NW and the Si branch. The discharge capacities and Coulombic efficiencies (C.E) for each composition cycled at a C/5 rate are shown in Figure 5a. The 2:1, 3:1 and 4:1 compositions exhibited initial discharge capacities of 1484, 1255 and 1249 mAh/g respectively, which increased to 1777, 1550 and 1325 mAh/g over the early cycling period. This rise in capacity is due to the innate property of Si to only partially lithiate over the initial cycles, forming a core-shell structure consisting of a c-Si core and a-Li₁₅Si₄ shell. As cycling progresses however, the crystalline core decreases in diameter upon each subsequent full charge. This results in an increase in capacity, until eventually the fully charged NW consists completely of a-Li₁₅Si₄. The exhibited capacities are below the maximum theoretical specific capacity calculated for each composition. This is more than likely as a consequence of the existence of a native oxide layer on the material as the substrates were exposed to the atmosphere during washing and weighing steps. The native oxide layers of both Ge and Si irreversibly alloy with Li leading to reduced capacities. The material exhibited 1^{st} cycle C.E. values of 65.8% (2:1), 68.1% (3:1) and 71.4% (4:1). As to be expected, the composition with the highest Si content has the lowest C.E., due to the fact that Si forms a much thicker native oxide layer than Ge. After 100 cycles, the samples displayed capacities of 1612 mAh/g (2:1), 1459 mAh/g (3:1) and 1256 mAh/g (4:1), corresponding to a capacity retention in each case of 91.0%, 94.1% and 94.8%. Significantly, it should be noted that the capacity retention of the branched NWs is considerably better than that of a pure Si NW electrode. This is evident from Figure 5b, which shows the normalised capacity retention of the Si-Ge branched NW heterostructures plotted alongside the capacity retention of a Si NW electrode with no Ge present. It can be seen that the Si NWs on their own only retained 82.9% of their initial capacity after 100 cycles, clearly illustrating the benefit of using Ge as a support structure for the cycling of Si.

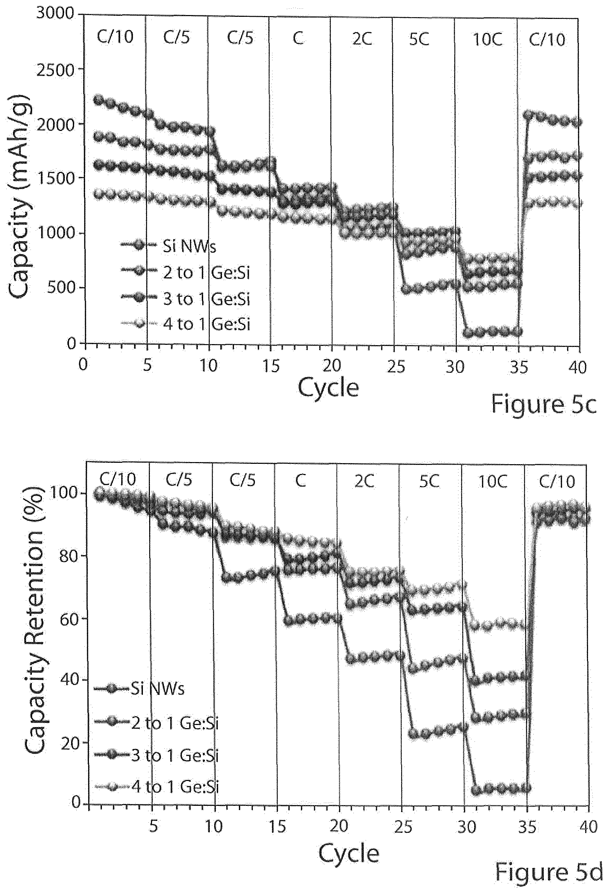

The rate capability of the branched NWs may be evaluated by charging and discharging the material for 5 cycles at rates of C/10, C/5, C/2, C, 2C, 5C, 10C and then back to C/10 (Figure 5c). As a comparison, the rate capability of a pure Si NW electrode can also be tested using the same experimental procedure. As to be expected, the electrodes with a higher Si content exhibited greater capacities at slower cycling rates, due to the larger intrinsic capacity of Si. At cycling rates of C/10 and C/5, it can be seen that the pure Si electrode is the best performer, exhibiting capacities of 2090 mAh/g and 1936 mAh/g respectively. However, as the cycling rates became more rapid, the composite electrodes began to outperform pure Si, due to the greater electrical conductivity of Ge and its higher rate of Li⁺ diffusivity. At a cycling rate of C/2, the 2:1 Ge/Si composition performs equally as well as the Si electrode, both exhibiting capacities of -1630 mAh/g, while at all rates above this it performed significantly better. A similar trend occurs for the other compositions, with the 3:1 electrode performing equally as well or better than the Si electrode at rates of 1C and above, and the 4:1 electrode outperforming the Si electrode at rates above 2C. It can be seen that all three branched NW electrodes display significantly higher capacities than Si at the two fastest rates, with the 4:1 electrode in particular performing very well at the 10C rate, exhibiting a capacity of 802 mAh/g, over six times that of the pure Si electrode (130 mAh/g).

Figure 5d shows the normalised capacity retention of the electrodes. This figure clearly shows the branched NWs retain considerably more relative capacity at each cycle rate than Si. It is obvious from the graph that the higher the Ge content in the electrode the greater the relative capacity retention, which is again a consequence of the advantageous rate characteristics of Ge. EIS measurements correlate well with these findings, as they reveal that the impedance of the branched NW heterostructure electrodes increases with increasing Si content, thus having a negative effect on the rate capability. Overall these results demonstrate the benefit of using a multi-element system, as by simply controlling the Ge:Si mass ratio it is possible to tailor the properties of the electrode for either high capacity or high rate capability depending on the power requirements of the application.

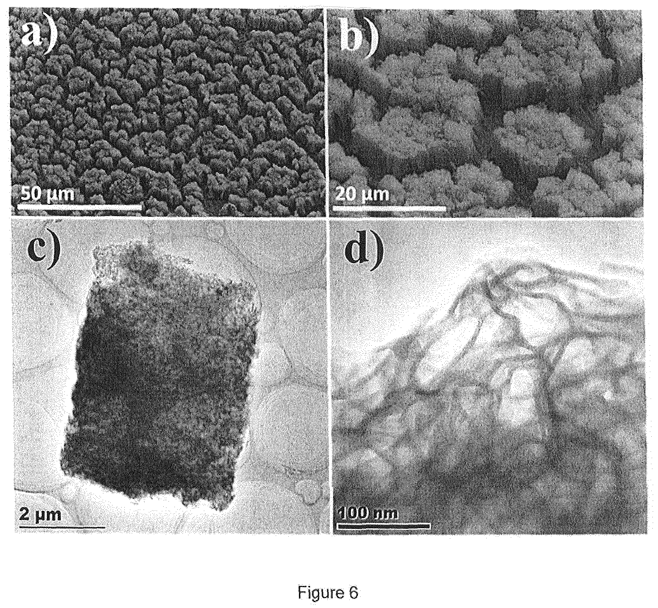

It will be appreciated that the method of the first embodiment of the present invention ensures that branch growth occurs along the entire length of the NW stem. As a result, it provides a highly interconnected branched NW structure. During use as an electrode, the cycling of this highly interconnected branched NWs causes the material to restructure into a stable porous network of ligaments of active material due to a phenomenon known as lithium assisted electrochemically welding. Thus, the composition of the material is transient in nature, transforming from a heterostructure to a Si-Ge alloy as a consequence of repeated lithiation and delithiation. Figure 6 shows SEM and TEM images of the branched NWs (2:1 composition) after 100 cycles. The SEM and TEM images reveal that the branched NW morphology has been replaced by the network of ligaments with the active material agglomerating into islands that remain well contacted to the current collector (Figure 6 a, b). The TEM images (Figure 6 c, d) reveal the sponge like nature and porosity of the restructured active material. This is highly advantageous, as the empty space can accommodate the volume changes associated with the charge / discharge processes, alleviating any stress build up that would otherwise be encountered by the material. Thus it produces a high-performing electrode with good capacity retention.

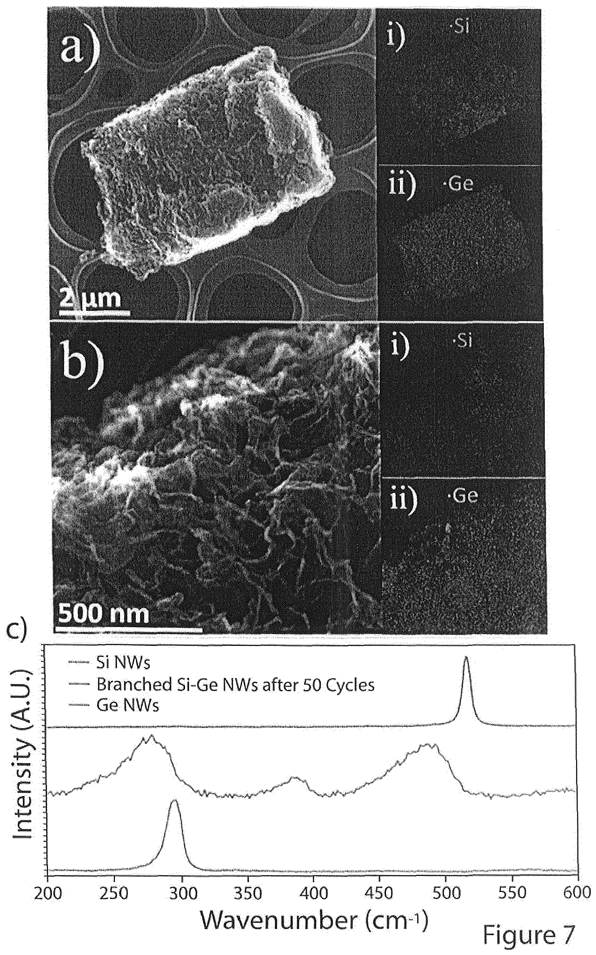

Figure 7 shows EDX mapping at low magnification (Figure 7a i and ii) and high magnification (Figure 7b i and ii). A relatively even dispersion of both Si and Ge throughout the network can be seen. These results suggest that the restructuring process has transformed the material from a Si-Ge heterostructure into a Si₁₋ₓGeₓ alloy, most likely due a phenomenon known as lithium assisted, electrochemical welding. Raman spectroscopy of the branched NW heterostructures after 100 cycles compared to a pure Si NW substrate and a pure Ge NW substrate (Figure 7c) confirm this transformation. The peak sizes of Si and Ge have been normalized to the height of the signal from the network. The Si NW substrate and Ge NW substrate show single, sharp peaks at 520 cm⁻¹ and 297 cm⁻¹ respectively, corresponding to c-Si and c-Ge. The Raman spectrum of the network after 100 cycles shows three broad peaks at 279, 387 and 489 cm⁻¹ and is consistent with the spectrum of a Si-Ge alloy. The transformation from heterostructure to alloy occurs as during lithiation Li atoms can bond simultaneously with Si and Ge at points of contact between the branch and the NW, creating a Si-Li-Ge bridge. During delithiation, this link is broken. This creates a kinetic driving force for Si-Ge bond formation at the interface, having the overall effect of decreasing the surface energy of the material. The vine like manner of growth of the Si branches around the Ge NW is likely to be an advantageous property in this regard, as the multiple contact points promote the fusion of Si and Ge through cycling, ultimately transforming the material from a Si-Ge heterostructure to a Si-Ge alloy network.

There are numerous advantages to an electrode incorporating the heterostructure of the present invention. Through the use of the secondary seeding technique of the invention, the branch density may be controlled, by varying the concentration of the nanoparticle colloidal solution. In addition, for the embodiment where the heterostructure is a Si-Ge heterostructure, the Si to Ge mass ratio in the electrode is controllable. Through the increase of the Ge content, the rate capability of the electrode is improved, thereby adapting the electrode for applications that require quick bursts of energy, such as for example power tools. Conversely, through the increase of the Si content, the electrode can display a higher capacity but lower rate capability, and therefore be adapted for applications that do not require very high discharge rates, such as mobile phone.

Furthermore, when used as an anode in a lithium-ion battery the NWs overcome the problem of pulverisation encountered by bulk electrodes previously mentioned. This is due to the fact that they undergo a complete restructuring of their morphology to form a porous network of interconnected alloy ligaments. This network remains well contacted to the current collector despite the restructuring process, and can accommodate the mechanical stresses associated with the charge and discharge process without further deformation. As a result of this, the electrode exhibits a very stable capacity over its lifetime and is mechanically robust. High capacities of ∼2000 mAh/g are readily achievable, well above the maximum theoretical capacity of commercially available graphitic materials (372 mAh/g).

In addition, since Sn is used as the secondary seed, it contributes to the overall capacity of the electrode, due to the fact that Sn reversibly alloys with Li during the charge/discharge process.

The present invention also provides a simple and scalable low energy process for NW heterostructure growth.

The SEI layer formed on the Si-Ge alloy network is also much more stable than that formed on Si NWs alone when used in conjunction with the electrolyte additive, vinylene carbonate. This means that the cycle life of the heterostructure electrode is much improved over a Si NW electrode on its own.

It should also be appreciated that each NW is directly contacted to the current collector, due to the fact that a vapour-liquid-solid growth mechanism is used to synthesise the material. This eliminates the need for binders and conductive additives, which lower the overall specific capacity of the anode. The mixing, coating, pressing and drying steps involved in electrode preparation using traditional slurry coating methods are eliminated making the process more efficient. In addition, the method of the present invention is more environmentally friendly, as the use of harsh solvents which are toxic, expensive and generate flammable vapours during processing are not required.

## Claims

1. A heterostructure for an electrode in a lithium ion battery wherein the heterostructure comprises:
a Germanium, Ge, nanowire stem;
a plurality of tin, Sn, nanoparticles attached to the nanowire stem; and
a plurality of branches of Silicon, Si, distributed along the entire length of the surface of the nanowire stem, wherein the plurality of branches of Si were grown from the surface of the nanowire stem by using the plurality of tin nanoparticles as secondary seeds.

2. The heterostructure of Claim 1, wherein the nanowire stem is in direct contact with a current collector.

3. The heterostructure of Claim 2, where the current collector comprises one of stainless steel, copper, nickel, aluminium or platinum.

4. The heterostructure of Claim 3, wherein the Ge to Si mass ratio is adapted to provide an electrode of a particular capacity and rate capability by controlling the size of the tin nanoparticles to provide a desired diameter of the Si branches.

5. A method for synthesising a heterostructure for an electrode in a lithium ion battery, the method comprising the steps of:
synthesising a Germanium, Ge, nanowire; and
depositing Silicon, Si, on the surface of the nanowire for a predetermined time period such that the Si is distributed along the entire length of the surface of the nanowire, wherein the step of depositing Si on the surface of the Ge nanowire comprises the steps of:
attaching a plurality of tin, Sn, nanoparticles to the nanowire; and
growing Si nanowire branches from the nanowire by means of the tin nanoparticles acting as a secondary seed material.

6. The method of Claim 5, further comprising selecting the size of the plurality of tin nanoparticles in accordance with the desired size of the nanowire branches.

7. The method of Claim 5 or Claim 6, further comprising selecting the concentration of the nanoparticle solution in accordance with the desired density of the plurality of the nanowire branches.

8. The method of any of Claims 5 to 7, wherein the step of attaching the plurality of tin, Sn, nanoparticles to the nanowire further comprises the steps of:
washing and performing a ligand exchange on the plurality of Sn nanoparticles using oleic acid to form a solution;
recovering the layer of solution containing the Sn nanoparticles; and covalently attaching the Sn nanoparticles to the nanowire via a molecular linker.

9. The method of any of Claims 5 to 8, wherein the step of synthesising the nanowire further comprises the steps of:
delivering a precursor to a preheated substrate provided with a pretreated current collector in an inert atmosphere; and
growing a nanowire from the current collector via a vapour-solid-solid mechanism or a vapour-liquid-solid mechanism.

## Patentansprüche

1. Heterostruktur für eine Elektrode in einer Lithium-Ionen-Batterie, wobei die Heterostruktur Folgendes umfasst:
einen Germanium (Ge)-Nanodrahtstamm;
eine Vielzahl von Zinn (Sn)-Nanopartikeln, die an dem Nanodrahtstamm angebracht sind; und
eine Vielzahl von Zweigen von Silicium (Si), die entlang der gesamten Länge der Oberfläche des Nanodrahtstamms verteilt sind, wobei die Vielzahl von Zweigen von Si von der Oberfläche des Nanodrahtstamms unter Verwendung der Vielzahl von Zinn-Nanopartikeln als sekundäre Keime wuchsen.

2. Heterostruktur nach Anspruch 1, wobei der Nanodrahtstamm in direktem Kontakt mit einem Stromabnehmer ist.

3. Heterostruktur nach Anspruch 2, wo der Stromabnehmer eines von Edelstahl, Kupfer, Nickel, Aluminium oder Platin umfasst.

4. Heterostruktur nach Anspruch 3, wobei das Masseverhältnis von Ge zu Si geeignet ist, um eine Elektrode einer bestimmten Kapazität und Ratenfähigkeit durch Regulierung der Größe der Zinn-Nanopartikel zur Bereitstellung eines gewünschten Durchmessers der Si-Zweige bereitzustellen.

5. Verfahren für die Synthese einer Heterostruktur für eine Elektrode in einer Lithium-Ionen-Batterie, wobei das Verfahren die folgenden Schritte umfasst:
Synthetisieren eines Germanium (Ge)-Nanodrahts; und
Abscheiden von Silicium (Si) auf der Oberfläche des Nanodrahts für eine vorgegebene Zeitdauer, sodass das Si entlang der gesamten Länge der Oberfläche des Nanodrahts verteilt wird, wobei der Schritt des Abscheidens von Si auf der Oberfläche des Ge-Nanodrahts die folgenden Schritte umfasst:
Anbringen einer Vielzahl von Zinn (Sn)-Nanopartikeln an den Nanodraht; und
Wachsen von Si-Nanodrahtzweigen von dem Nanodraht mithilfe der Zinn-Nanopartikel, die als sekundäres Keimmaterial agieren.

6. Verfahren nach Anspruch 5, das weiter das Auswählen der Größe der Vielzahl von Zinn-Nanopartikeln entsprechend der gewünschten Größe der Nanodrahtzweige umfasst.

7. Verfahren nach Anspruch 5 oder Anspruch 6, das weiter das Auswählen der Konzentration der Nanopartikellösung entsprechend der gewünschten Dichte der Vielzahl der Nanodrahtzweige umfasst.

8. Verfahren nach einem der Ansprüche 5 bis 7, wobei der Schritt des Anbringens der Vielzahl von Zinn (Sn)-Nanopartikeln an den Nanodraht weiter die folgenden Schritte umfasst:
Waschen und Durchführen eines Ligandenaustausches an der Vielzahl von Sn-Nanopartikeln unter Verwendung von Ölsäure, um eine Lösung zu bilden;
Rückgewinnen der Schicht der Lösung, die die Sn-Nanopartikel enthält; und kovalentes Anbringen der Sn-Nanopartikel an den Nanodraht über einen molekularen Linker.

9. Verfahren nach einem der Ansprüche 5 bis 8, wobei der Schritt des Synthetisierens des Nanodrahts weiter die folgenden Schritte umfasst:
Abgeben eines Vorläufers an ein vorgewärmtes Substrat, das mit einem vorbehandelten Stromabnehmer bereitgestellt ist, in einer inerten Atmosphäre; und
Wachsen eines Nanodrahts von dem Stromabnehmer über einen Dampf-Feststoff-Feststoff-Mechanismus oder einen Dampf-Flüssigkeits-Feststoff-Mechanismus.

## Revendications

1. Hétérostructure pour une électrode dans une batterie lithium-ion, l'hétérostructure comprenant :
une tige de nanofil en germanium, Ge ;
une pluralité de nanoparticules en étain, Sn, fixées à la tige de nanofil ; et
une pluralité de ramifications en silicium, Si, distribuées tout le long de la surface de la tige de nanofil, la pluralité de ramifications en Si ayant grandi à partir de la surface de la tige de nanofil en utilisant la pluralité de nanoparticules en étain comme germes secondaires.

2. Hétérostructure selon la revendication 1, dans laquelle la tige de nanofil se trouve en contact direct avec un collecteur de courant.

3. Hétérostructure selon la revendication 2, dans laquelle le collecteur de courant comprend l'un parmi de l'acier inoxydable, du cuivre, du nickel, de l'aluminium ou du platine.

4. Hétérostructure selon la revendication 3, dans laquelle le rapport massique du Ge au Si est adapté afin de fournir une électrode d'une capacité et d'une aptitude de débit particulières, par le contrôle de la taille des nanoparticules en étain afin de fournir un diamètre désiré des ramifications de Si.

5. Méthode de synthèse d'une hétérostructure pour une électrode dans une batterie lithium-ion, la méthode comprenant les étapes consistant à :
synthétiser un nanofil en germanium, Ge ; et
déposer du silicium, Si, à la surface du nanofil pendant une période de temps prédéterminée de façon à distribuer le Si tout le long de la surface du nanofil, où l'étape de dépôt de Si à la surface du nanofil en Ge comprend les étapes consistant à :
fixer une pluralité de nanoparticules en étain, Sn, au nanofil ; et
faire croître des ramifications de nanofil en Si à partir du nanofil en utilisant les nanoparticules en étain comme matériau de germes secondaires.

6. Méthode selon la revendication 5, comprenant en outre la sélection de la taille de la pluralité des nanoparticules en étain conformément avec la taille souhaitée des ramifications du nanofil.

7. Méthode selon la revendication 5 ou la revendication 6, comprenant en outre la sélection de la concentration de la solution de nanoparticules conformément avec la densité souhaitée de la pluralité des ramifications du nanofil.

8. Méthode selon l'une quelconque des revendications 5 à 7, dans laquelle l'étape de fixation de la pluralité des nanoparticules en étain, Sn, au nanofil, comprend en outre les étapes consistant à :
laver et mettre en œuvre un échange de ligands sur la pluralité de nanoparticules en Sn en utilisant de l'acide oléique afin de former une solution ;
récupérer la couche de solution contenant les particules en Sn ; et fixer de manière covalente les nanoparticules en Sn au nanofil via un bras de liaison moléculaire.

9. Méthode selon l'une quelconque des revendications 5 à 8, dans laquelle l'étape de synthèse du nanofil comprend en outre les étapes consistant à :
apporter un précurseur à un substrat préchauffé pourvu d'un collecteur de courant prétraité dans une atmosphère inerte ; et
faire croître un nanofil à partir du collecteur de courant via un mécanisme de vapeur-solide-solide ou un mécanisme de vapeur-liquide-solide.
